(19) Europäisches Patentamt
European Patent Office
Office européen des brevets

(11) **EP 2 796 884 B1**

(12) **FASCICULE DE BREVET EUROPEEN**

(45) Date de publication et mention de la délivrance du brevet:
**06.01.2016 Bulletin 2016/01**

(21) Numéro de dépôt: **14165742.9**

(22) Date de dépôt: **24.04.2014**

(51) Int Cl.:
**G01P 15/08** *(2006.01)*

(54) **Structure microélectromecanique et/ou nanoélectromecanique à facteur de qualité ajustable**

Mikroelektromechanische und/oder nanoelektromechanische Struktur mit einstellbarer Qualitätsfaktor

Microelectromechanical and/or nanoelectromechanical structure with ajustable quality factor

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.04.2013 FR 1353789**

(43) Date de publication de la demande:
**29.10.2014 Bulletin 2014/44**

(73) Titulaire: **Commissariat à l'Énergie Atomique et aux Énergies Alternatives 75015 Paris (FR)**

(72) Inventeurs:
• **Deimerly, Yannick 38000 GRENOBLE (FR)**
• **Jourdan, Guillaume 69530 BRIGNAIS (FR)**
• **Rey, Patrice 38430 ST JEAN DE MOIRANS (FR)**

(74) Mandataire: **Ilgart, Jean-Christophe BREVALEX 95, rue d'Amsterdam 75378 Paris Cedex 8 (FR)**

(56) Documents cités:
**US-A1- 2010 181 156     US-A1- 2011 252 887 US-B2- 7 273 762**

• **MARCO S ET AL: "Analysis of electrostatic-damped piezoresistive silicon accelerometers", SENSORS AND ACTUATORS A, ELSEVIER SEQUOIA S.A., LAUSANNE, CH, vol. 37-38, 1 juin 1993 (1993-06-01), pages 317-322, XP026576904, ISSN: 0924-4247, DOI: 10.1016/0924-4247(93) 80053-J [extrait le 1993-06-01]**

EP 2 796 884 B1

**Description**

**DOMAINE TECHNIQUE ET ART ANTÉRIEUR**

La présente invention se rapporte à une structure microélectromécanique et/ou nanoélectromécanique à facteur de qualité ajustable, notamment à un capteur inertiel à facteur de qualité ajustable.

Par exemple, le capteur inertiel est un accéléromètre, un gyroscope, un magnétomètre ou un capteur de pression formé par un système microélectromécanique (MEMS pour "MicroElectroMechanical System") et/ou nanoélectromécanique (NEMS pour "NanoElectroMechanical System").

De manière générale, le facteur de qualité d'un micro ou nanosystème peut s'exprimer comme la somme des inverses des diverses sources de dissipation ou d'amortissement. Généralement la principale source d'amortissement vue par un système microélectromécanique et/ou nanoélectromécanique est l'amortissement visqueux.

Un gyroscope présente un facteur de qualité donné.

L'électronique du gyroscope est alors dimensionnée pour une certaine plage de facteur de qualité. Or il peut être intéressant de pouvoir faire varier le facteur de qualité lors de la phase de démarrage du gyroscope. Par exemple en abaissant le facteur de qualité, la plage de démarrage de la boucle à verrouillage de phase ou PLL ("Phase-locked loop" en terminologie anglaise) est élargie. Et en augmentant le facteur de qualité, on peut obtenir un meilleur actionnement.

Par ailleurs, il existe une demande de plus en plus grande pour des structures intégrant plusieurs systèmes microélectromécaniques (MEMS pour "MicroElectroMechanical System") et/ou nanoélectromécaniques, par exemple intégrant au moins un gyroscope et au moins un accéléromètre.

Ces systèmes sont généralement isolés dans des cavités, notamment afin de les protéger de l'environnement extérieur. Les systèmes peuvent alors être disposés dans deux cavités distinctes ou dans la même cavité.

Dans ce dernier cas plus particulièrement les deux systèmes sont nécessairement dans un environnement à la même pression.

Or, un gyroscope requiert un coefficient de qualité élevé pour des raisons de sensibilité, un coefficient de qualité élevé étant obtenu par exemple en disposant le gyroscope dans un environnement à faible pression. A l'inverse un accéléromètre non résonant ou passif, i.e. ne requérant pas de moyens d'excitation pour son fonctionnement, nécessite un facteur de qualité faible, sinon il peut présenter un comportement non linéaire, voire être endommagé en cas de choc. Un faible facteur de qualité peut être obtenu en disposant l'accéléromètre dans un environnement à pression ambiante, afin d'assurer un certain amortissement de l'accéléromètre.

Par conséquent, l'intégration d'un accéléromètre et d'un gyroscope dans la même cavité pose des problèmes pour assurer le bon fonctionnement des deux capteurs.

**EXPOSÉ DE L'INVENTION**

C'est par conséquent un but de la présente invention d'offrir un dispositif comportant au moins un système micro et/ou nanoélectromécanique comportant des moyens permettant de faire varier son facteur de qualité de manière simple et intégrables relativement facilement à la structure du système micro et/ou nanoélectromécanique.

Le but précédemment énoncé est atteint par un système micro et/ou nanoélectromécanique comportant des moyens d'amortissement électromécanique comprenant un circuit électrique dans lequel sont connectés en série une alimentation, au moins une résistance électrique et au moins un condensateur à capacité variable, ledit condensateur étant intégré à la structure du système micro et/ou nanoélectromécanique, de sorte qu'un déplacement de la masse suspendue du système provoque une variation de la capacité du condensateur.

En d'autres termes, on introduit dans un système micro et/ou nanoélectromécanique une source d'amortissement de la masse suspendue, ce qui permet de faire varier le facteur de qualité.

Dans un exemple très avantageux, au moins un des condensateurs à capacité variable est formé en partie par une électrode prévue pour tester le système.

Ainsi, les moyens d'amortissement utilisent des moyens existants dans le système, leur réalisation est donc simplifiée.

De manière préférée, la résistance est réalisée au plus près du système, par exemple elle est réalisée dans le substrat, par exemple en gravant une jauge dans le substrat et/ou en modifiant son dopage, ce qui permet de limiter les capacités parasites et d'obtenir de grandes valeurs de résistance.

La source d'amortissement peut être commandable. Par exemple, dans le cas d'un gyroscope, une telle source d'amortissement permet de réduire son facteur de qualité au démarrage.

Dans le cas d'un dispositif intégrant un gyroscope et un accéléromètre dans une même cavité à pression faible, le facteur de qualité de l'accéléromètre peut être réduit de manière simple grâce à l'invention de sorte à compenser la faible pression. La pression est par exemple de 1 mBar à quelques mBars.

La présente invention a alors pour objet une structure microélectromécanique et/ou nanoélectromécanique comportant au moins une partie fixe et au moins une partie suspendue par rapport à la partie fixe et des moyens d'amortissement du déplacement de la partie suspendue par rapport à la partie fixe, lesdits moyens d'amortissement étant des moyens d'amortissement électromécaniques comportant au moins une source d'alimentation continue, au moins une résistance électrique et au moins un condensateur à capacité variable en série avec la résistance, ledit au moins condensateur et ladite au moins résistance formant avec la source d'alimentation au moins une boucle , ledit condensateur à capacité variable étant formé en partie par la partie suspendue et en partie par la partie fixe de sorte qu'un déplacement de la partie suspendue provoque une variation de capacité du condensateur à capacité variable.

De manière avantageuse, la structure comporte au moins n ensembles comprenant une résistance électrique et un condensateur à capacité variable en série avec la résistance, lesdits n ensembles étant connectés en parallèle sur la source d'alimentation continue, de sorte à former n boucles ayant la même source d'alimentation.

De manière très avantageuse, n est un nombre pair et la structure comporte une partie fixe à n motifs électriquement indépendants, les n condensateurs à capacité variable des n ensembles étant formés par lesdites n motifs de la partie fixe, ces derniers étant disposés de part et d'autre de la partie suspendue par rapport à un plan de symétrie de ladite partie suspendue.

Dans un exemple de réalisation, la masse inertielle comporte un peigne muni de n dents, et la partie fixe comporte un peigne muni de n dents formants n motifs, les deux peignes étant interdigités, de sorte qu'une dent d'un peigne forme avec une dent d'un autre peigne un condensateur à capacité variable.

Dans un exemple, le au moins un condensateur à capacité variable est par exemple à variation d'entrefer.

La variation d'entrefer entre les deux électrodes du condensateur peut varier d'une extrémité à l'autre dudit condensateur, par exemple dans le cas où les deux électrodes du condensateur ne sont pas parallèles entre elles.

Dans un autre exemple, le au moins condensateur à capacité variable est à variation de surface.

Avantageusement, au moins une électrode du au moins un condensateur à capacité variable est formée par au moins une électrode de test de la structure.

De manière préférée, la résistance électrique est formée en partie par la partie fixe.

La résistance peut être réalisée, avantageusement intégrée à la partie fixe, par exemple par gravure d'un support destiné à former au moins en partie cette partie fixe et/ou par report d'un élément sur la partie fixe et/ou par dopage du support formant au moins en partie cette partie fixe. Le motif formée alors par cette résistance peut-être par exemple celui d'une poutre ou d'un serpentin suspendu ou non par rapport au substrat. La partie fixe peut être le substrat dans lequel est réalisée la partie suspendue ou un substrat formant un capot.

Les moyens d'amortissement peuvent être commandables de sorte à appliquer un effort d'amortissement variable.

La structure peut comporter des moyens de détection des déplacements de la partie suspendue et former un capteur inertiel. Le capteur inertiel peut alors être un accéléromètre.

La structure peut comporter des moyens d'excitation d'au moins une partie de la partie suspendue. Les moyens d'amortissement peuvent alors être commandables de sorte à appliquer un effort d'amortissement variable, le capteur inertiel étant un gyroscope.

La présente invention a également pour objet un ensemble comportant au moins deux capteurs inertiels, intégrés sur le même substrat, au moins un des deux capteurs inertiels est un capteur inertiel selon la présente invention. L'ensemble peut comporter un gyroscope et un accéléromètre selon la présente invention, ledit gyroscope et ledit accéléromètre étant avantageusement encapsulés dans une même cavité, grâce à l'utilisation de moyens d'amortissement tels que l'accéléromètre présente un facteur de qualité faible.

Avantageusement la cavité dans laquelle est encapsulé l'accéléromètre est sous faible pression

La présente invention a également pour objet un procédé de réalisation d'une structure ou d'un ensemble selon la présente invention, comportant les étapes :

- réalisation d'au moins une résistance électrique des moyens d'amortissement sur un support destiné à former au moins en partie la partie fixe,
- réalisation de la partie suspendue et de la partie fixe de la structure,
- libération au moins de la partie suspendue.

L'étape de réalisation de ladite au moins une résistance électrique comporte une étape de dopage de manière à contrôler la résistivité électrique de la partie du matériau dans laquelle est réalisée la au moins une résistance.

Le procédé réalisation peut comporter une étape de formation d'une couche de protection sur ladite résistance électrique avant la réalisation de la partie suspendue et de la partie fixe de la structure.

## BRÈVE DESCRIPTION DES DESSINS

La présente invention sera mieux comprise à l'aide de la description qui va suivre et des dessins en annexes sur lesquels:

-   la figure 1A est une représentation schématique d'un système microélectromécanique mettant en oeuvre des moyens d'amortissement selon l'invention,
-   la figure 1B est une représentation schématique d'une variante avantageuse du système de la figure 1, dans laquelle les moyens d'amortissement agissent de manière symétrique sur la masse inertielle,
-   la figure 2 est une représentation schématique d'un autre exemple de réalisation d'un système microélectromécanique mettant en oeuvre des moyens d'amortissement selon l'invention offrant un amortissement augmenté,
-   les figures 3A, 3B et 3C sont des vues de dessus de réalisations pratiques de trois exemples de réalisation d'un système microélectromécanique selon l'invention,
-   la figure 4A est une représentation graphique typique de la fonction de transfert d'un système micro électromécanique
-   la figure 4B est un zoom de la figure 4A qui est une représentation graphique de la fonction de transfert du système pour plusieurs valeurs de résistance électrique,
-   la figures 5 est une représentation graphique de l'amortissement produit par les moyens d'amortissement sur la masse inertielle en fonction de la valeur de la résistance électrique des moyens d'amortissement,
-   la figure 6 est une représentation graphique du coefficient d'amortissement produit par les moyens d'amortissement sur la masse inertielle en fonction de la tension d'alimentation des moyens d'amortissement,
-   la figure 7 est une représentation graphique du facteur de qualité du système en fonction de la tension d'alimentation des moyens d'amortissement,
-   la figure 8 est une vue de dessus d'un dispositif intégrant un gyroscope et un accéléromètre, ce dernier étant muni de moyens d'amortissement selon l'invention,
-   les figures 9A à 9I sont des représentations schématiques des différentes étapes de réalisation d'un système selon l'invention selon un exemple de procédé de réalisation,
-   les figures 10A et 10B sont des représentations schématiques d'exemple de réalisation de résistance pouvant être mises en oeuvre dans la présente invention,
-   la figures 11A reprend la figure 1B complétée,
-   la figure 11B est une représentation schématique d'une variante du système de la figure 1B dans laquelle les deux ensembles R, C sont en série avec deux sources d'alimentation distinctes.
-   la figure 12 est une représentation schématique d'un exemple de système selon l'invention mettant en oeuvre deus masses inertielles couplées,
-   la figure 13 est une représentation schématique d'un exemple de système selon l'invention mettant en oeuvre deux ensembles R, C agissant de manière non symétrique sur la masse inertielle,
-   la figure 14 est une représentation schématique d'un exemple d'accéléromètre selon l'invention dans lequel les moyens de détection utilisent une jauge dont on mesure la variation de fréquence de résonance transverse.

## EXPOSÉ DÉTAILLÉ DE MODES DE RÉALISATION PARTICULIERS

Dans la description un système microélectromécanique ou nanoélectromécanique sera désigné MEMS.

Dans une application, un tel système est un système inertiel. Il peut être un système inertiel résonant ou actif, i.e. mettant en oeuvre des moyens d'excitation et les moyens de détection, tel qu'un gyroscope ou un accéléromètre actif ou il peut être un capteur inertiel non résonant ou passif, i.e. ne mettant pas en oeuvre de moyens d'excitation, le signal à mesurer étant produit par l'environnement extérieur uniquement, comme par exemple un accéléromètre, un magnétomètre, un capteur de pression.

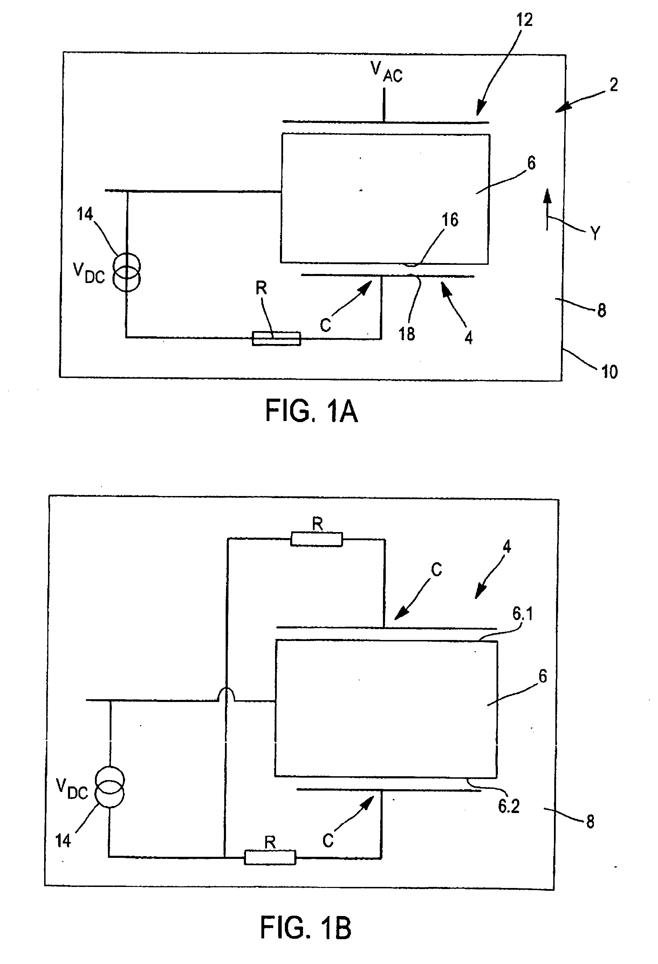

La figure 1A est une représentation schématique d'un MEMS 2 et de moyens d'amortissement électromécanique 4. Le MEMS 2 comporte une partie suspendue 6 par rapport à une partie fixe 8 sur un substrat 10, la partie suspendue 6 formant une masse inertielle. Le MEMS 2 comporte également des moyens de détection 12 de type capacitif dans l'exemple représenté. Par exemple, le MEMS 2 est un accéléromètre; une accélération provoque le déplacement de la masse inertielle 6 par rapport à la partie fixe 8, le déplacement relatif des peignes est alors détecté par mesure de la variation de capacités.

Dans l'exemple de la figure 1A, les moyens d'amortissement électromécanique 4 comportent une source d'alimentation en tension continue 14, une résistance électrique R et un condensateur à capacité variable C, connectés en série formant une boucle. Le condensateur à capacité variable C est tel que sa capacité dépend de la position de la masse inertielle 6 par rapport à la partie fixe 8.

Dans la présente demande, une source d'alimentation en tension continue peut être à tension constante ou à charge constante.

Dans l'exemple représenté de manière schématique, le condensateur C est représenté par deux plaques 16, 18 en regard, une plaque 16 étant fixe par rapport à la masse inertielle 6 et l'autre plaque 18 étant fixe par rapport à la partie fixe 8. Ainsi, lorsque la masse inertielle se déplace, les plaques 16, 18 se rapprochent ou s'éloignent provoquant une variation de la capacité du condensateur par variation d'entrefer.

Le condensateur est orienté en fonction du déplacement attendu de la masse inertielle. Sur la figure 1A, le déplacement attendu se fait le long de l'axe Y, lors de ce déplacement les plaques 16, 18 se rapprochent ou s'éloignent.

La résistance électrique R peut être rapportée sur le substrat et être connectée au condensateur et à la source d'alimentation 14.

De préférence, la résistance est intégrée au plus près du MEMS, ce qui permet de réduire les capacités parasites. Pour cela, la résistance est avantageusement réalisée dans le substrat, par exemple par gravure, la résistance étant alors similaire à une jauge ou à une poutre. Elle présente une longueur importante relativement à son épaisseur à et à sa largeur de sorte à présenter une grande résistance électrique. En outre, de manière encore préférée, le dopage du matériau du substrat formant la résistance est modifié de sorte à atteindre une valeur de résistance relativement élevée.

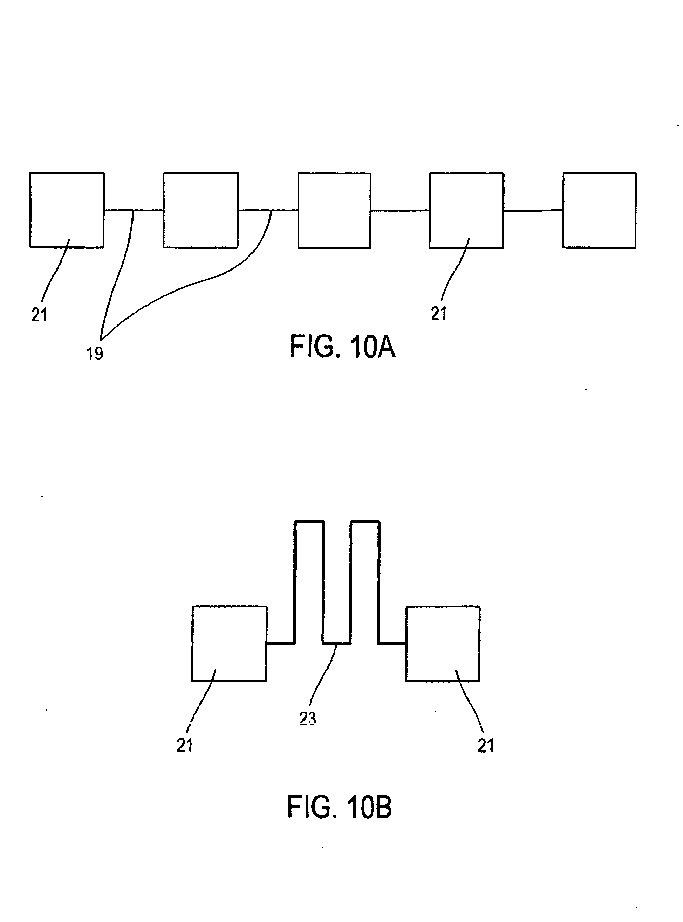

Cette résistance est isolée électriquement du reste du système. Elle peut être en forme de jauge, de poutre ou de filament, en outre elle peut être suspendue ou non. Sur la figure 10A, on peut voir un exemple schématique d'une résistance formée de plusieurs poutres suspendues 19, les poutres 19 étant reliées pas des ancrages 21. Sur la figure 10B, la résistance est formée par un filament 23 ancré à ses deux extrémités par des ancrages 21. Le filament a, dans l'exemple représenté, la forme d'un serpentin, mais cette forme n'est en aucun cas limitative.

Un isolement électrique par jonction pn, i.e. en réalisant un changement de dopage brutal, peut être envisagé. Cet isolement présente l'avantage de ne pas recourir à la mise en oeuvre d'une "poutre" suspendue au sens mécanique du terme.

En variante, on peut réaliser cette jauge ou poutre dans un autre matériau que celui du substrat, le matériau présentant des propriétés de résistance électrique souhaitées.

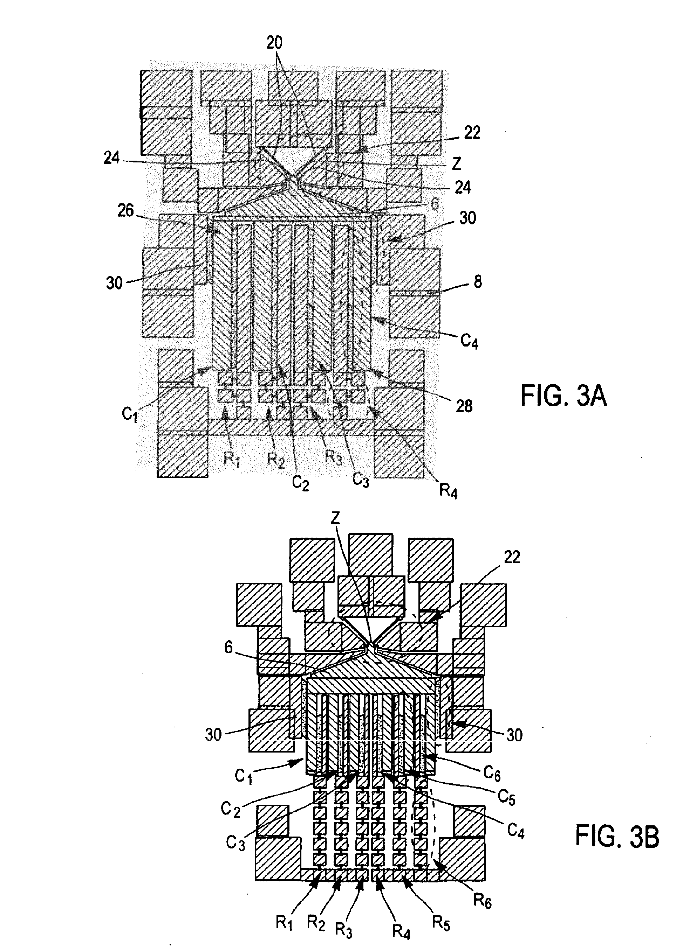

Il sera compris que la résistance R peut être formée de plusieurs résistances électriques en série, comme cela est par exemple représenté sur les figures 3A à 3B.

Les moyens d'amortissement fonctionnent de la manière suivante : en polarisant la boucle avec une tension non nulle, une force d'attraction électrostatique apparaît entre les plaques du condensateur. Par ailleurs, un déplacement de la masse inertielle 6 provoque une variation de capacité, qui provoque une variation du courant circulant dans la boucle. Le courant ainsi généré est transformé en chaleur dans la résistance.

L'énergie dissipée par effet Joule est donc liée au mouvement de la masse inertielle. Cette dissipation d'énergie assure un amortissement électromécanique du déplacement de la masse inertielle.

Sur la figure 1B, on peut voir un autre exemple avantageux des moyens d'amortissement 4 selon l'invention. Les moyens d'amortissement 4 sont disposés symétriquement par rapport à la masse inertielle 6 et agissent symétriquement sur celle-ci, ce qui évite au système de sortir de sa position d'équilibre et réduit les risques de collage. Dans la représentation schématique de la figure 1B, les moyens d'amortissement comportent une résistance R et un condensateur C en série, le condensateur dont une des plaques ou électrodes est portée par un bord 6.1 de la masse inertielle et une résistance R et un condensateur C en série, condensateur dont une des plaques ou électrodes est portée par le bord 6.2 opposé de la masse inertielle selon la direction Y.

Grâce à cet amortissement symétrique, le système reste autour de sa position d'équilibre. En laissant le système proche de sa position d'équilibre, l'amortissement ne modifie pas d'autres performances du capteur, telles que sa sensibilité ou sa gamme dynamique.

Il sera compris que l'invention permet de réaliser aussi un amortissement dissymétrique, auquel cas, le système fonctionne hors de sa zone d'équilibre réduisant légèrement sa gamme de fonctionnement. L'amortissement obtenu est équivalent en termes d'amplitude et sa mise en place plus simple, puisqu'il peut ne mettre en oeuvre par exemple qu'une seule résistance et une seule capacité variable.

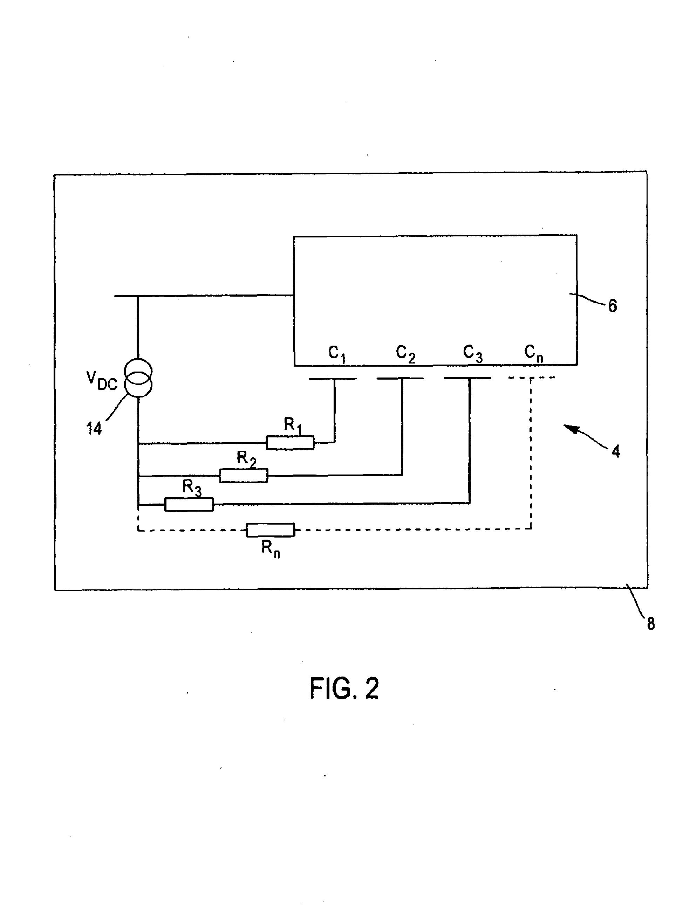

Sur la figure 2, on peut voir un autre exemple de réalisation dans lequel les moyens d'amortissement 4 comportent une source de tension continue $V_{DC}$ 14, n couples de résistance R1, R2,..., Rn et de condensateur à capacité variable C1, C2,..., Cn en série, les couples étant connectés en parallèle à la source de tension. Ainsi les moyens d'amortissement comportent plusieurs couples RC ayant chacune sa propre fréquence de coupure. Les amortissements produits par chacune des boucles s'ajoutent tout en conservant une fréquence de coupure inchangée.

En effet, l'amortissement lui-même possède une fonction de transfert avec gain et une fréquence de coupure. Ainsi, pour une fréquence de travail donnée, il existe une limite pour les valeurs de résistance et de capacité au-delà de laquelle l'amortissement devient nul. En mettant en oeuvre un seul couple RC en série avec la source de tension, l'amortissement est limité afin que la fréquence d'utilisation soit inférieure à la fréquence de coupure.

En associant plusieurs couples RC en parallèle, on peut augmenter l'amortissement, puisque celui-ci résulte de la somme des amortissements de chacun des couples RC, sans abaisser la fréquence de coupure, celle-ci étant égale à la moyenne des fréquences de coupure de chacun des couples RC.

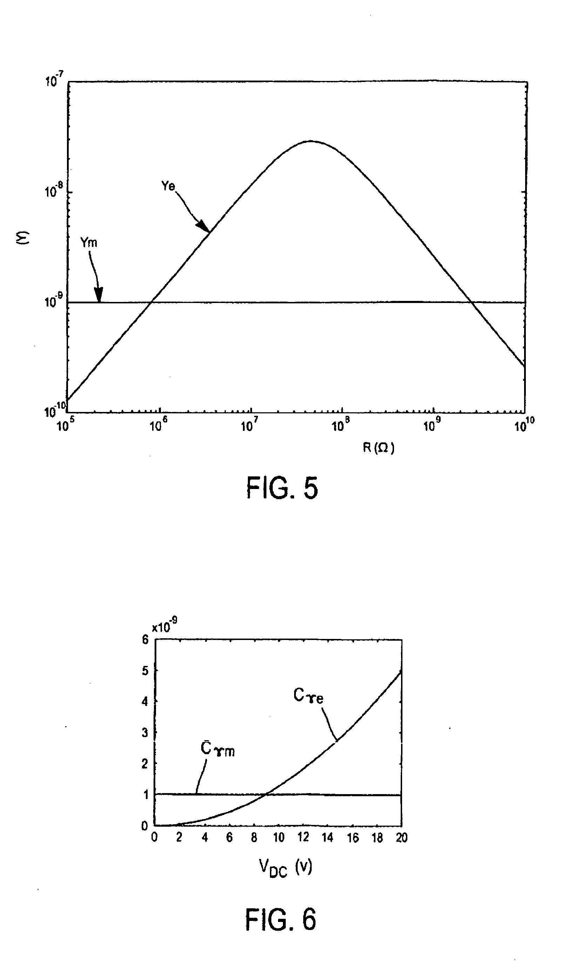

En variante, l'amortissement peut être augmenté avec un seul couple RC en série avec une source d'alimentation en augmentant la tension d'alimentation comme cela est illustré par la représentation graphique de la figure 6 qui sera décrite ci-dessous.Les moyens d'amortissement 4 pourraient être réalisés de sorte qu'ils soient symétriques par rapport à la masse inertielle comme sur la figure 1B, le même nombre de couples R, C agirait de chaque côté de la masse inertielle.

Cette configuration permet en outre d'éliminer les termes non linéaires et des composantes de force statique en équilibrant les efforts exercés par au moins deux jeux d'électrodes / résistances

En prenant l'exemple où un couple RC agit de chaque côté. Cette configuration permet d'équilibrer les efforts statiques produits par la polarisation des capacités C1 et C2. Lorsque la masse est au repos, la somme des efforts électrostatiques qui s'exercent sur la masse est nulle. De plus les termes non linéaires produits pour chacune des deux forces F1 et F2 se compensent.

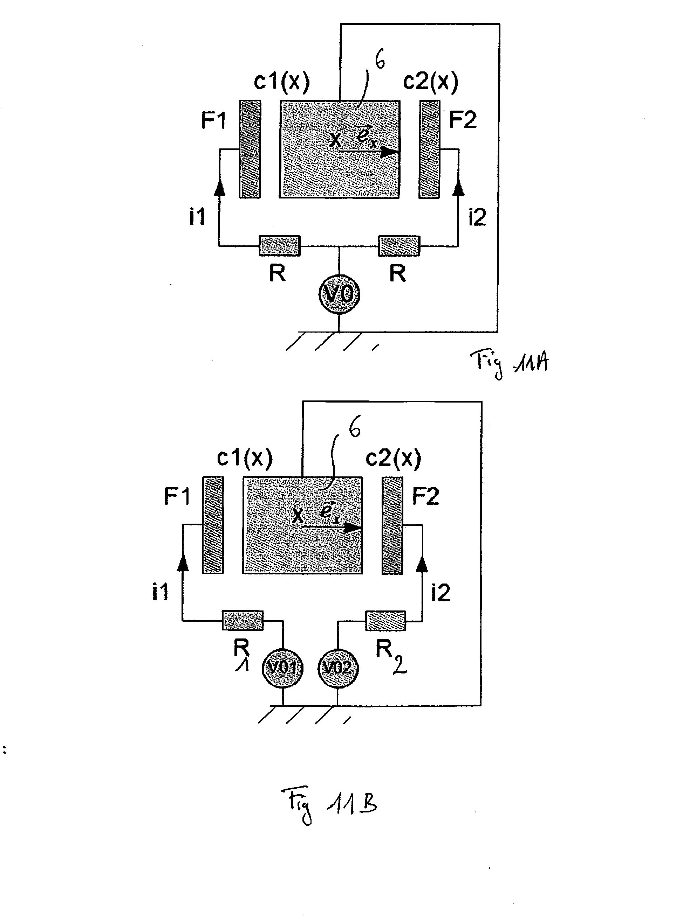

Sur la figure 11A, sont représentées les forces appliquées par les condensateurs et les courants circulants dans les couples.

Toutes configurations qui vérifient :

$$C1' = -C2' = C'( 1 )$$

C'étant la dérivée de C par rapport au degré de liberté x) Permet d'atteindre ce résultant.

En effet :

Les forces sur la masse d'écrivent : $\overrightarrow{F_1} = 0.5 C_1' V_1^2$ et $\overrightarrow{F_2} = 0.5 C_2' V_2^2$

Les tensions aux bornes des capacités : $V_1 = V_0 - R i_1$ et $V_2 = V_0 - R i_2$

Les courants $i_1 = V_0 C_1' \dot{x}$ et $i_2 = V_0 C_2' \dot{x}$

Compte tenu de (1), la force totale sur le système s'écrit :

$$\vec{F} = \overrightarrow{F_1} + \overrightarrow{F_2} = 0.5 C'(V_1^2 - V_2^2)$$

$$\vec{F} = 2R V_0^2 C'^2 \dot{x} \overrightarrow{e_x}$$

Alors que la force générée par une seule électrode génère trois composantes :

$$\overrightarrow{F_1} = 0.5 C'(V_0^2 - 2V_0^2 R C' \dot{x} + (R V_0 C' \dot{x})^2)$$

Or, les première et dernière composantes pourraient apporter des nuisances pour le bon fonctionnement du MEMS.

Sur la figure 11B, on peut voir un exemple de moyens d'amortissement comportant deux ensembles R1, C1 et R2, C2 disposés symétriquement par rapport à la masse inertielle 6, chaque ensemble R1, C1 et R2, C2 étant en série avec sa propre source d'alimentation V01, V02 respectivement. Cette configuration permet d'assurer l'équilibre des forces si le système n'est pas équilibré, i.e. si R1 et R2 sont différents et/ou si C1 et C2 sont différents.Sur la figure 3A, on peut voir un exemple de réalisation pratique d'une structure comportant un MEMS et des moyens d'amortissement selon l'exemple de réalisation de la figure 2.

Le MEMS 2 comporte une masse inertielle 6 mobile en rotation autour d'un axe Z par rapport à la partie fixe 8. La masse inertielle 6 est suspendue par rapport à la partie fixe 8 au moyen de deux poutres 20 sécantes formant la liaison pivot 22 d'axe Z.

Les moyens de détection sont formés par deux jauges piézorésistives 24 montées en différentielle disposées de part et d'autre de la liaison pivot 22. Lorsque l'une des jauges 24 est déformée en extension l'autre est déformée en compression. En variante, on pourrait ne prévoir qu'une seule jauge.

Les moyens d'amortissement 4 comportent plusieurs condensateurs à capacité variables, quatre dans l'exemple représenté désignés par C1, C2, C3, C4. Chaque condensateur est formé par une dent d'un peigne 26, solidaire de la masse inertielle et une dent en regard d'un peigne 28 solidaire de la partie fixe. Dans l'exemple représenté, chaque peigne est muni de quatre dents, les dents étant interdigitées. Les dents de chaque peigne 26, 27 sont isolées électriquement entre elles et les dents des deux peignes sont isolées les unes des autres. Des résistances R1, R2, R3, R4 sont formées dans le substrat et connectées en série avec chacun des condensateurs. Dans l'exemple représenté, les résistances sont sous forme de jauges suspendues. Pour chaque condensateur, plusieurs éléments résistifs sont connectés en série afin d'atteindre la valeur de résistance souhaitée et sont connectés en série avec un condensateur. Chaque condensateur en série avec une ou plusieurs éléments résistifs forment un couple RC. Les moyens d'amortissement comportent alors plusieurs couples RC en parallèle.

Le pivotement de la masse inertielle autour de l'axe Z provoque un écartement ou un rapprochement des dents des peignes et donc une variation des capacités des condensateurs C1, C2, C3, C4. Dans cet exemple de réalisation, les variations de capacité se font principalement par variation des surfaces en regard.

Les électrodes désignées 30 forment des électrodes de test destinées à vérifier le bon fonctionnement du MEMS. Dans l'exemple représenté, ces électrodes n'interviennent pas dans les moyens d'amortissement.

Les couples de condensateur et de résistance sont connectés en parallèle à la source d'alimentation continue (non représentée). Comme expliqué en relation avec la figure 2, les amortissements s'additionnent tout en conservant une fréquence de coupure constante.

Sur la figure 3B, on peut voir une variante du système de la figure 3A, dans laquelle les moyens d'amortissement comportent six condensateurs à capacités variables formés par deux peignes interdigités. Comme pour le système de la figure 3A, les dents des peignes sont isolées électriquement les unes des autres les résistances R1 à R6 sont formés par plusieurs éléments résistifs en série. Dans cette variante, les éléments résistifs sont alignés, alors que dans le système de la figure 3A, les éléments résistifs sont orientés de sorte à former des structures compactes.

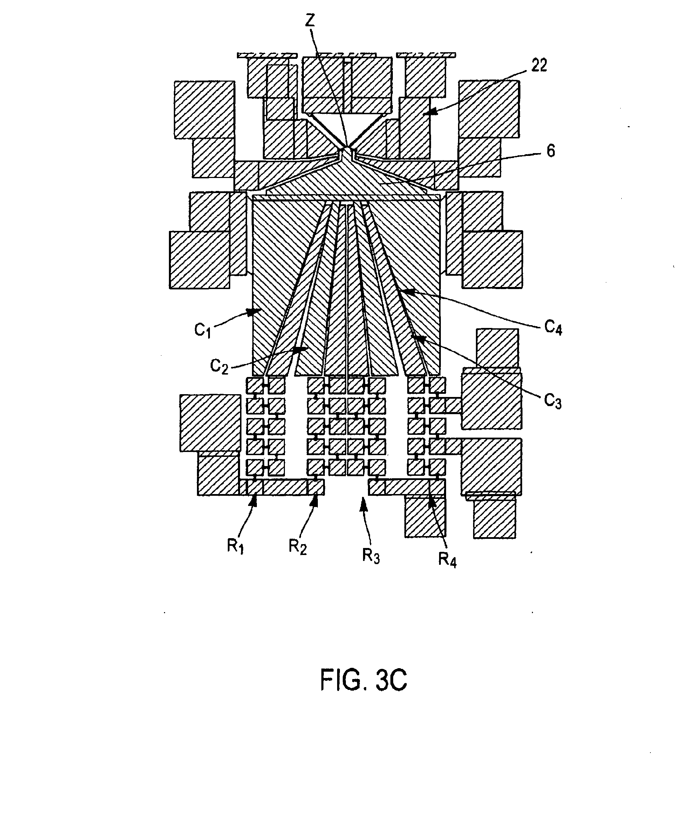

Sur la figure 3C, on peut voir un autre exemple de réalisation, dans lequel les dents des peignes présentent des axes concourants au niveau de l'axe de rotation. La structure est organisée autour de l'axe de rotation. Les résistances sont similaires à celles du système de la figure 3A. Dans cette variante, les variations de capacité résultent d'une variation d'entrefer.

Dans les systèmes de figures 3A, 3B et 3C, les moyens d'amortissement sont réalisés de manière symétrique par rapport à la masse inertielle de sorte à appliquer un amortissement par couplage électromécanique symétrique à la masse inertielle.

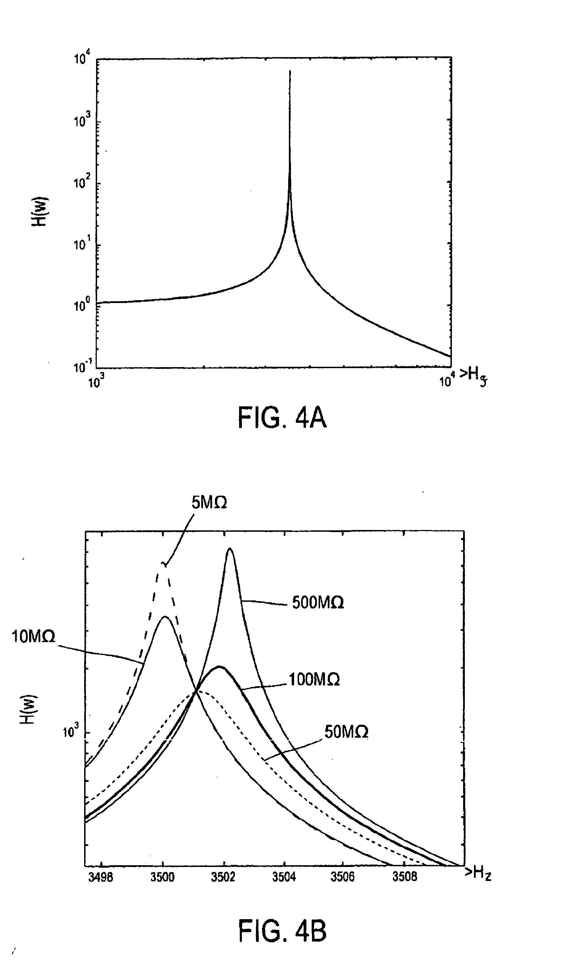

Sur la figure 4A, est représentée la fonction de transfert générale du déplacement de la masse inertielle en fonction de la fréquence en Hz par exemple du système de la figure 3A ou de la figure 3B.

La fonction de transfert totale du déplacement du système peut s'écrire :

$$\frac{X}{F} = \frac{1}{k - m\omega^2 + \dfrac{C'^2 R^2 . V_0^2 \omega^2 C}{1 + R^2 C^2 \omega^2} + j\left(\omega\gamma_m + \dfrac{C'^2 . R . V_0^2 \omega}{1 + R^2 C^2 \omega^2}\right)}$$

Avec k la raideur du système,

m la masse de la masse inertielle,

C la capacité au repos du condensateur équivalent des moyens d'amortissement,

C' la variation de capacité due à un déplacement x,

$V_0$ la tension continue polarisant le(s) couple(s) RC,

$\gamma_m$ l'amortissement mécanique du système.

En séparant la partie réelle et la partie imaginaire, on obtient un terme d'inertie négative, qui modifie la fréquence de résonance du système ;

$$\frac{C'^2 R^2 . V_0^2 \omega^2 C}{1 + R^2 C^2 \omega^2},$$

et

un terme d'amortissement électromécanique :

$$\frac{C'^2 . R . V_0^2 \omega}{1 + R^2 C^2 \omega^2}.$$

On peut considérer la valeur de l'amortissement additionnel dû au couplage électromécanique en dessous de la fréquence de coupure comme étant proportionnelle à : $\gamma = C'^2 R . V_0^2$.

L'amortissement varie donc effectivement en fonction de la résistance électrique.

Sur la figure 4B, on peut voir un zoom de la fonction de transfert en fonction de la fréquence en hertz pour différentes valeurs de la résistance électrique des moyens d'amortissement.

On constate, au vu de la figure 4B, que la fréquence de résonance varie en fonction de la valeur de la résistance.

On constate également que l'amortissement n'est pas proportionnel à la valeur de la résistance. En effet, en-deçà d'une certaine valeur de la résistance, l'amortissement augmente, et au-delà de cette valeur l'amortissement diminue. On a alors atteint la fréquence de coupure.

L'amortissement peut être contrôlé au moyen de la valeur de la ou des résistances et de la source d'alimentation.

Sur la figure 5, on peut voir la variation de l'amortissement mécanique $\gamma$m et électromécanique ye en fonction de résistance R pour une fréquence donnée.

L'amortissement électromécanique s'écrit : $\dfrac{C'^2 R.V_0^2}{1 + R^2 C^2 \omega^2}$ .

L'amortissement mécanique $\gamma$m est constant et est indépendant de la valeur de R. L'amortissement électromécanique ye varie en fonction de R et passe par un maximum.

Dans l'exemple représenté, la fréquence a été fixée à 3500 Hz.

L'amortissement électromécanique atteint son maximum pour une valeur de résistance électrique R égale à 45,5 M$\Omega$.

Sur la figure 6, on peut voir la variation de coefficient d'amortissement mécanique Cym et électromécanique Cye en fonction de différentes tensions d'alimentation des moyens d'amortissement pour une résistance de 10 M$\Omega$.

L'amortissement mécanique $\gamma$m est constant et est indépendant de la valeur de la tension d'alimentation. L'amortissement électromécanique ye augmente de manière quadratique avec la tension d'alimentation.

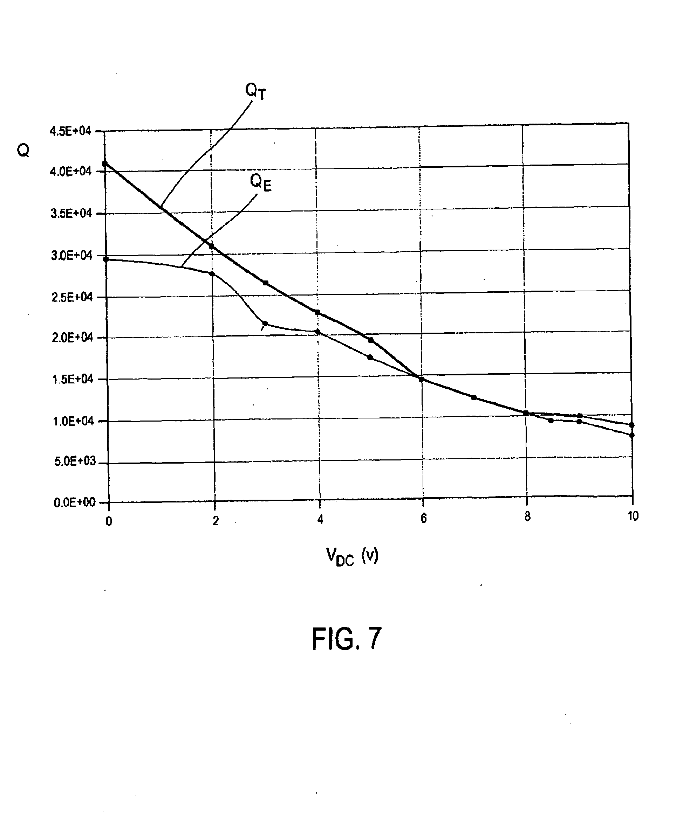

En outre, sur la figure 7, est représentée la variation du facteur de qualité mesurée expérimentalement $Q_E$ et la variation du facteur de qualité théorique $Q_T$ en fonction de la tension d'alimentation. Le facteur de qualité baisse donc avec l'augmentation de la tension de commande. La valeur du facteur de qualité peut alors être aisément contrôlée en fonction de la tension d'alimentation.

Ainsi en choisissant la résistance R et/ou la valeur de la source d'alimentation ou le courant d'alimentation, il est possible d'obtenir l'amortissement souhaité et donc le facteur de qualité souhaité. Par conséquent, grâce à l'invention, le facteur de qualité d'une structure peut être réglé très facilement et peut même être commandé au cours du fonctionnement de la structure en commandant la valeur de l'alimentation continue.

Comme mentionné ci-dessus, les moyens d'amortissement peuvent comporter un condensateur à variation de surface ou à variation d'entrefer.

Dans le cas d'un ou plusieurs condensateurs à variation d'entrefer, la capacité C s'écrit: $C = \dfrac{\varepsilon_0 S}{g}$

Avec S la surface des places, g l'entrefer et $\varepsilon_0$ la permittivité de l'air.

L'amortissement est proportionnel à la variation de capacité C'.

C' s'écrit :

$$C' = \frac{\partial C}{\partial x} = \frac{\varepsilon_0 S}{2(g-x)^2}$$

Avec x le déplacement entre les deux plaques du condensateur.

C' est alors proportionnelle à l'inverse du carré de la valeur de l'entrefer.

Par conséquent l'amortissement est bien proportionnel à la variation d'entrefer.

Du fait des contraintes des procédé de fabrication utilisé en microélectronique, les condensateurs à variation d'entrefer ont l'avantage de présenter un meilleur rapport C'/C, par rapport aux condensateurs à variation de surface, ce qui permet d'atteindre des amortissements plus importants. Cependant leur utilisation peut entraîner des phénomènes de pull-in et générer des raideurs négatives plus importantes que les peignes interdigités.

Le saut au contact ou pull-in en anglais est un effet électrostatique présent entre autre dans les condensateurs à variation d'entrefer (plan-plan). Lorsqu'on applique une tension entre les deux plaques mobile du condensateur elle se rapproche l'une de l'autre. Si la tension est trop forte les deux plaques viennent se collé l'une contre l'autre. On appel cette tension critique, la tension de pull-in.

De plus, l'utilisation de condensateur à variation d'entrefer permet de maximiser l'effet de d'amortissement par film d'air. Ainsi, outre l'amortissement par couplage électromécanique, les moyens d'amortissement amplifient l'amortissement par film d'air.

Dans un autre mode de réalisation, les moyens d'amortissement pourraient comporter en outre une inductance.

De tels moyens d'amortissement permettraient d'obtenir un couplage électromécanique d'ordre 2, et ainsi d'avoir un facteur de qualité supérieur à 1.

Le MEMS peut être un gyroscope. Les moyens d'amortissement sont alors de préférence des moyens d'amortissement commandables, permettant de modifier l'amortissement et donc de modifier le facteur de qualité du gyroscope au cours du fonctionnement du gyroscope.

Avantageusement, les moyens d'amortissement sont commandés de sorte qu'au démarrage du fonctionnement du gyroscope le facteur de qualité est réduit, ce qui a pour effet d'élargir la plage de démarrage de la boucle à verrouillage de phase (PLL). Les moyens d'amortissement sont ensuite commandés afin d'augmenter le facteur de qualité du gyroscope.

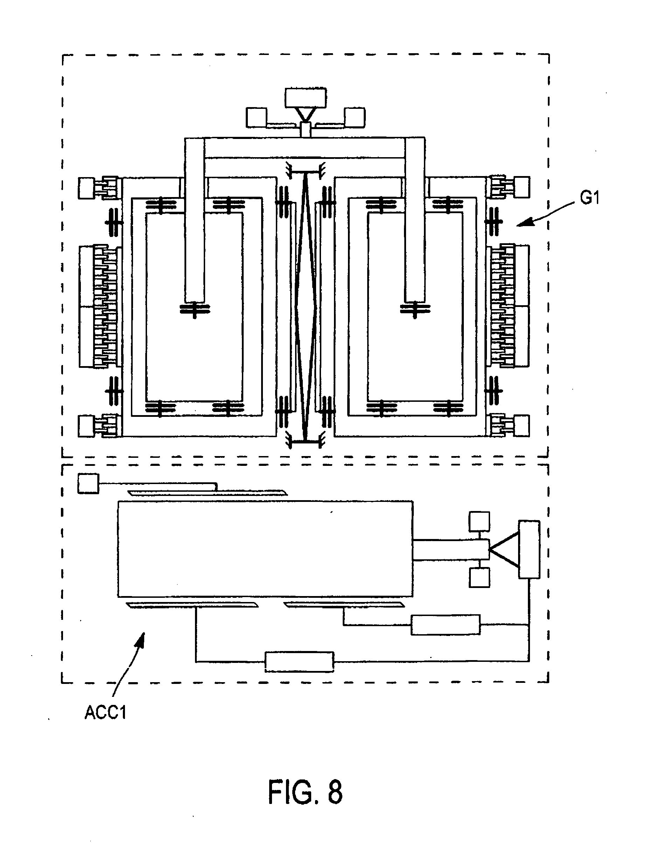

Le MEMS peut être un accéléromètre qui est encapsulé sous une pression faible, les moyens d'amortissement sont alors tels qu'ils diminuent le facteur de qualité de l'accéléromètre. Cette encapsulation à faible pression est particulièrement intéressante dans le cas d'accéléromètre encapsulé avec un gyroscope qui requiert une faible pression pour son fonctionnement. Ainsi il est possible de réaliser des systèmes combinant gyroscope G1-accéléromètre Acc1 tout en assurant un bon fonctionnement à la fois du gyroscope et de l'accéléromètre. Un tel dispositif est représenté sur la figure 8.

L'accéléromètre ACC1 comporte les moyens d'amortissement selon l'invention.

Les moyens d'amortissement peuvent également être appliqués à tout capteur inertiel, tel qu'un capteur de pression ou un magnétomètre.

De manière particulièrement intéressante, l'énergie dissipée lors de l'amortissement vient uniquement du résonateur. Le courant dans la boucle de dissipation étant alternatif et la tension étant continue (et stationnaire), la puissance fournie par la source de tension continue au cours d'une période est globalement égale à 0. Par conséquent l'apport en énergie est nul.

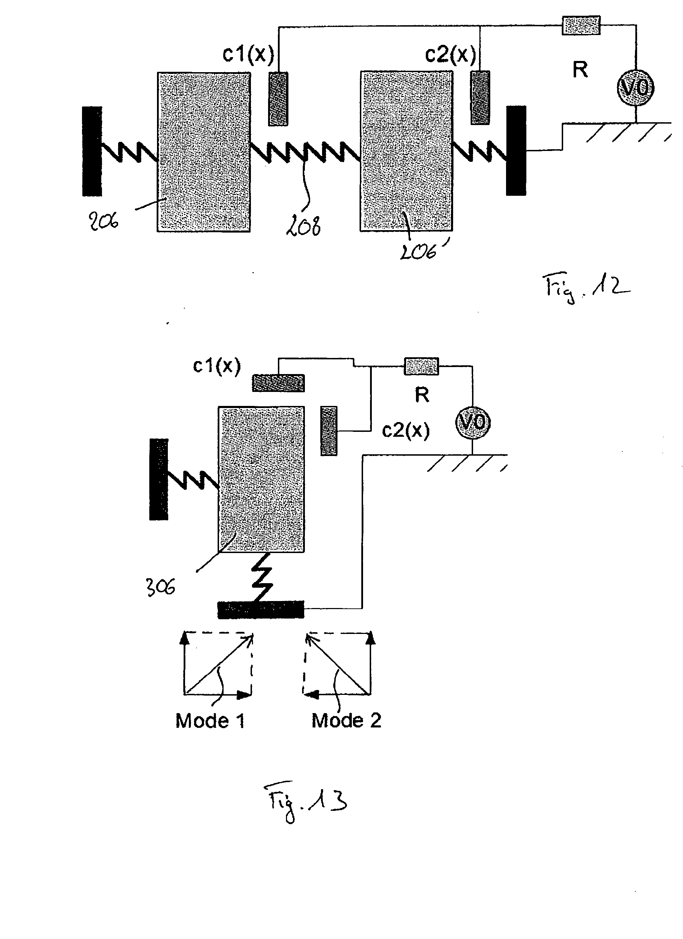

Sur la figure 12, on peut voir un exemple de disposition d'ensembles de capacité-résistance permettant d'amortir de manière préférentielle un mode de vibration.

Sur la figure 12 le système comporte deux masses inertielles 206, 206' couplées par un ressort de couplage 208.

Un condensateur C1, C2 est associé à chaque masse et les deux condensateurs sont associés à une même résistance et sont placés en parallèle. Seuls les modes de vibration pour lesquels $C(x)=C1(x)+C2(x)$ sont conservés constants pendant le mouvement associé au mode ne sont pas amortis.

Il est possible d'amortir le mode antiphase par l'utilisation de deux capacités distinctes.

Sur la figure 13, le système comporte un seule masse inertielle 306, les deux condensateurs C1,C2 agissant sur deux côtés perpendiculaires de la masse. Les deux condensateur sont également associés à la même résistance. Il est alors par exemple possible d'amortir le mode 1.

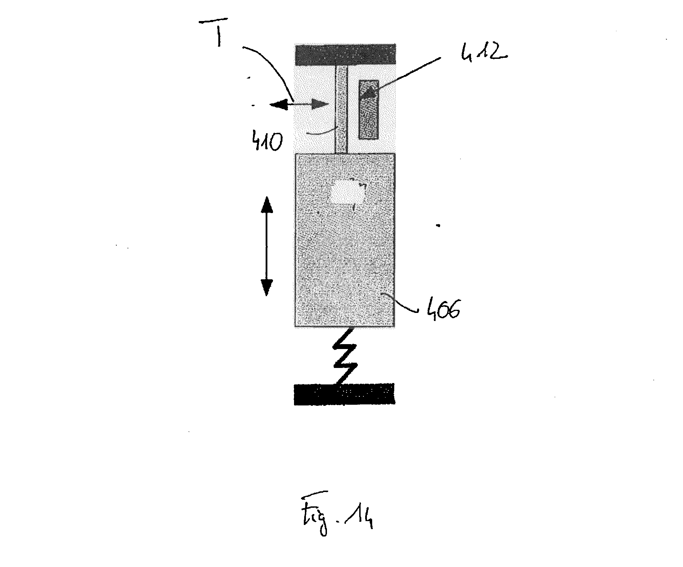

Sur la figure 14, on peut voir un exemple de système inertielle, par exemple un accéléromètre dans lequel les moyens de détection de déplacement de la masse 406 sont formés par une jauge 410 par exemple piézorésistive, mais dans lesquels la détection utilise non pas la variation de résistance électrique de la jauge mais la variation de la fréquence de résonance dans le mode transverse de la jauge désigné par le flèche T. Afin d'avoir une bonne résolution de la variation de la fréquence de résonance de la jauge, celle-ci doit offrir un bon facteur de qualité. La variation de la fréquence de résonance est par exemple mesuré par une détection capacitive 412.

Dans ce cas l'accéléromètre est avantageusement disposé dans une cavité sous faible pression, le mode de vibration de l'accéléromètre est amorti grâce aux moyens d'amortissement de l'invention (non représentés) et la jauge, et plus généralement les organes de transduction présentent de bons facteurs de qualité du fait de la faible pression.

Nous allons maintenant décrire un exemple de procédé de réalisation d'uns structure MEMS munie de moyens d'amortissement selon la présente invention.

Dans l'exemple décrit ci-dessous, la structure MEMS est un accéléromètre mais tout autre dispositif peut être réalisé par ce procédé.

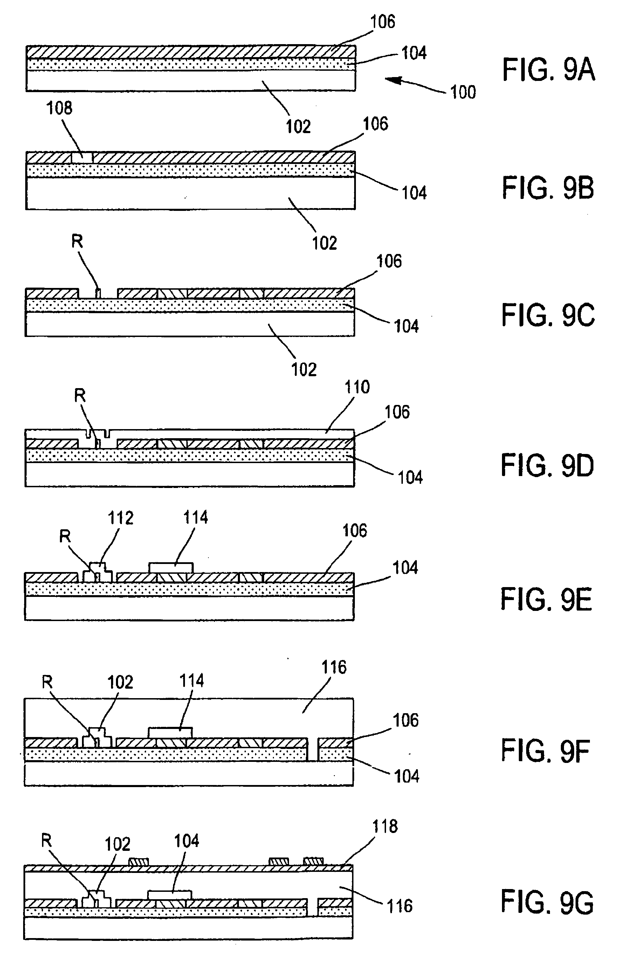

Dans l'exemple décrit, on utilise un substrat SOI (Silicium sur isolant ou "Silicon On Insulator" en terminologie anglaise). Le substrat 100 comporte un couche de silicium 102 désignée généralement Bulk, une couche d'oxyde 104 et une couche de silicium 106 recouvrant la couche d'oxyde 104. Le substrat 10 est représenté schématiquement sur la figure 9A.

Par exemple, la couche de silicium en surface 106 a une épaisseur comprise entre 0,1 $\mu$m et 100 $\mu$m et la couche d'oxyde enterrée 104 a une épaisseur comprise entre 0,5 $\mu$m et 5 $\mu$m. Par exemple, la couche de silicium a une épaisseur de 250 nm et une couche d'oxyde a une épaisseur de 1 $\mu$m.

Lors d'une première étape, on effectue une implantation de dopants sur toute la couche sauf dans une zone donnée 108 dans laquelle sera formée la résistance électrique des moyens d'amortissement. Pour cela on utilise par exemple un masque photosensible pour délimiter la zone à implanter qui est éliminé par la suite.

Ensuite, on effectue de préférence une homogénéisation des dopants implantés dans toute l'épaisseur de la couche de silicium 106 en effectuant un recuit, par exemple à 1050°C pendant 5 min.

L'élément ainsi formé est représenté sur la figure 9B.

Lors d'une étape suivante, on réalise une lithographie pour délimiter la résistance R ou jauge résistive destinée à former les moyens d'amortissement et ensuite une gravure de la couche de silicium 106 avec un arrêt sur la couche d'oxyde 104. La gravure est par exemple une gravure ionique réactive profonde (en anglais Deep Reactive Ion Etching DRIE). Dans l'exemple représenté, on réalise simultanément le ou les jauges 24 piézorésistives destinées à la détection du déplacement de la masse mobile.

L'élément ainsi formé est représenté sur la figure 9C.

Lors d'une étape suivante, on forme une couche de $SiO_2$ 110 sur la couche de silicium gravée 106, par exemple par plasma haute densité (HDP "high density plasma" en anglais) sur une profondeur de 250 nm.

Cette couche forme une couche de protection pour la résistance R réalisée ci-dessus et les jauges piézorésistives 24

L'élément ainsi formé est représenté sur la figure 9D.

Lors d'une étape suivante, on effectue une lithographie sur la couche 110 de sorte à délimiter une portion de protection 112 de la résistance R et et une portion 114 protège le ou les jauges piézorésistives, les portions de protection sont destinées à protéger la résistance et les jauges contre les gravures qui vont suivre.

On effectue ensuite une gravure de la couche 110 avec arrêt sur le silicium.

Le masque est retiré et une étape de nettoyage a lieu.

L'élément ainsi formé est représenté sur la figure 9E.

Lors d'une étape suivante, on forme une couche de silicium 116 sur l'élément de la figure 10E, par exemple par croissance épitaxiale sur une épaisseur de 20 $\mu$m, de préférence cette croissance a lieu en quatre étapes de sorte à former quatre couches de 5 $\mu$m.

Ensuite une étape de polissage mécano-chimique a lieu.

L'élément ainsi formé est représenté sur la figure 9F.

Lors d'une étape suivante, on forme une couche de AlSi 118.

L'élément ainsi formé est représenté sur la figure 9G.

Lors de l'étape suivante on réalise une lithographie de manière à définir le MEMS. On dépose un masque puis on grave à la fois les couches 116 et 118.

Par une seconde gravure de la couche 118, on définit la reprise de contact et les pistes conductrices.

Un nettoyage peut ensuite avoir lieu.

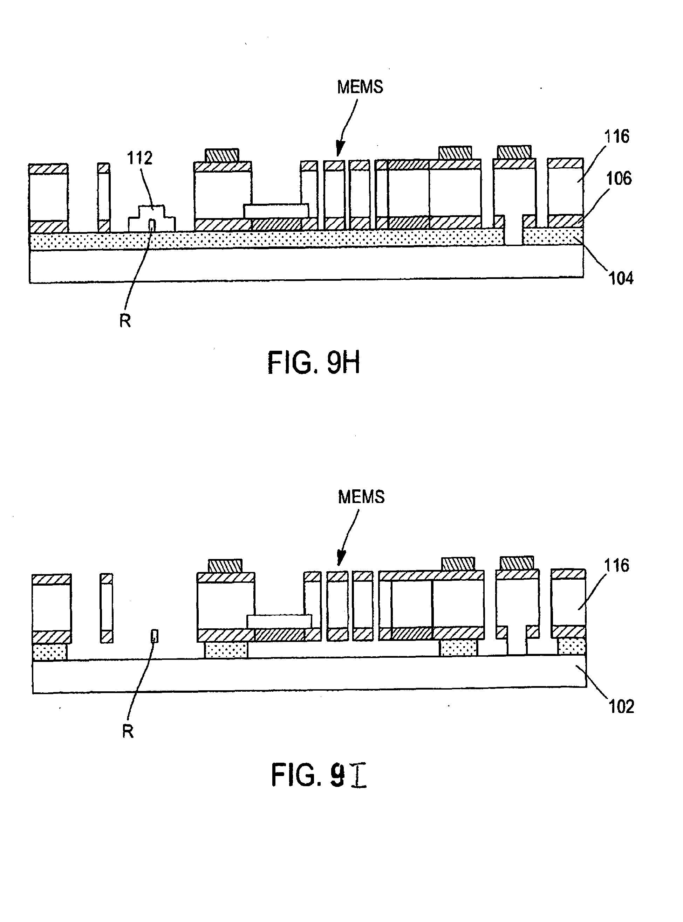

L'élément ainsi formé est représenté sur la figure 9H.

Enfin, les structures suspendues sont libérées par exemple par gravure à l'acide fluorhydrique; il s'agit par exemple d'une gravure au temps. L'accéléromètre et la jauge formant la résistance électrique des moyens d'amortissement sont ainsi libérés.

L'élément ainsi formé est représenté sur la figure 9I.

Un capot est avantageusement reporté sur le substrat muni du dispositif ainsi obtenu. Le scellement peut se faire de manière connue.

Le procédé de réalisation de la structure accéléromètre et moyens d'amortissement est peu complexifié par rapport au procédé de réalisation de l'accéléromètre seul. L'intégration des moyens d'amortissement selon l'invention dans une structure microélectronique requiert un niveau de masque.

En variante, on peut envisager de réaliser la ou les résistances sur le capot et ensuite de la ou les connecter avec le ou les condensateurs réalisés sur le substrat portant le dispositif. Les étapes de réalisation de la ou des résistances sont similaires à celles décrites ci-dessus pour la réalisation de la ou des résistances sur le substrat muni du dispositif.

Dans ce cas, lors de l'assemblage avec le substrat muni du dispositif, des contacts sont prévus afin d'assurer la connexion électrique entre la ou les résistances et le condensateurs réalisés sur le substrat portant le dispositif, de sorte à former un eutectique, par exemple Or/Silicium. En variante, il peut s'agir d'un eutectique Al/Ge ou Au/Sn.

**Revendications**

1. Structure microélectromécanique et/ou nanoélectromécanique comportant au moins une partie fixe (8) et au moins une partie suspendue (6) par rapport à la partie fixe (8) et des moyens d'amortissement (4) du déplacement de la partie suspendue (6) par rapport à la partie fixe (8), lesdits moyens d'amortissement (4) étant des moyens d'amortissement électromécaniques comportant au moins une source d'alimentation continue (14), au moins n ensembles comprenant une résistance électrique (R1,...Rn) et un condensateur à capacité variable (C1,...Cn) ou un sous ensemble de condensateurs à capacité variable connectés en parallèle entre eux, le condensateur ou le sous-ensemble de condensateurs étant relié en série avec la résistance, lesdits n ensembles étant connectés en parallèle sur la source d'alimentation continue (14), de sorte à former n boucles ayant la même source d'alimentation ou chaque ensemble étant connecté à une source d'alimentation continue, chaque condensateur à capacité variable (C) étant formé en partie par la partie suspendue (6) et en partie par la partie fixe (8) de sorte qu'un déplacement de la partie suspendue (6) provoque une variation de capacité dudit condensateur à capacité variable (C).

2. Structure selon la revendication 1, dans lequel les résistances d'au moins deux ensembles sont confondues.

3. Structure selon la revendication 1 ou 2, dans laquelle n est un nombre pair et la structure comporte une partie fixe à n motifs électriquement indépendants, les n condensateurs (C1,...Cn) à capacité variable des n ensembles étant formés par lesdites n motifs de la partie fixe, ces derniers étant disposés de part et d'autre de la partie suspendue (6) par rapport à un plan de symétrie de ladite partie suspendue (6).

4. Structure selon l'une des revendications 1 à 3, dans laquelle la partie suspendue comporte un peigne muni de n dents, et la partie fixe comporte un peigne muni de n dents formants n motifs, les deux peignes étant interdigités, de sorte qu'une dent d'un peigne forme avec une dent d'un autre peigne un condensateur à capacité variable.

5. Structure selon l'une des revendications 1 à 4, dans laquelle le au moins condensateur à capacité variable (C) est à variation d'entrefer.

6. Structure selon l'une des revendications 1 à 4, dans laquelle le au moins condensateur à capacité variable (C) est à variation de surface.

7. Structure selon l'une des revendications 1 à 6, dans laquelle au moins une électrode du au moins un condensateur à capacité variable (C) est formée par au moins une électrode de test (30) de la structure.

8. Structure selon l'une des revendications 1 à 7, dans laquelle la résistance électrique (R) est formée en partie par la partie fixe.

9. Structure selon l'une des revendications 1 à 8, dans laquelle les moyens d'amortissement sont commandables de sorte à appliquer un effort d'amortissement variable.

10. Structure selon l'une des revendications 1 à 9, comportant des moyens de détection des déplacements de la partie suspendue et formant un capteur inertiel.

11. Structure selon la revendication 10, dans laquelle le capteur inertiel est un accéléromètre.

12. Structure selon la revendication 10, comportant des moyens d'excitation d'au moins une partie de la partie suspendue.

13. Structure selon la revendication 12, dans laquelle les moyens d'amortissement sont commandables de sorte à appliquer un effort d'amortissement variable et dans laquelle le capteur inertiel est un gyroscope.

14. Ensemble comportant au moins deux capteurs inertiels, intégrés sur le même substrat, au moins un des deux capteurs inertiels est un capteur inertiel selon l'une des revendications 10 à 13.

15. Ensemble selon la revendication 14, comportant un gyroscope et un accéléromètre selon les revendications 11 et 13, ledit gyroscope et ledit accéléromètre étant encapsulés dans une cavité, les moyens d'amortissement étant tels que l'accéléromètre présente un facteur de qualité faible.

16. Procédé de réalisation d'une structure ou d'un ensemble selon l'une des revendications 1 à 15, comportant les étapes:

- réalisation d'au moins une résistance électrique des moyens d'amortissement sur ou dans un substrat destiné à former au moins en partie la partie fixe,
- réalisation de la partie suspendue et de la partie fixe de la structure
- libération au moins de la partie suspendue.

17. Procédé de réalisation selon la revendication 16, dans laquelle, la réalisation de ladite au moins une résistance électrique comporte une étape de dopage de manière à contrôler la résistivité électrique de la partie du matériau dans laquelle est réalisée la résistance (R).

18. Procédé de réalisation selon la revendication 16 ou 17, comportant une étape de formation d'une couche de protection sur ladite résistance électrique avant la réalisation de la partie suspendue et de la partie fixe de la structure.

**Patentansprüche**

1. Mikroelektromechanische und/oder nanoelektromechanische Struktur, umfassend wenigstens ein festes Teil (8) und ein relativ zum festen Teil (8) aufgehängtes Teil (6), sowie Mittel (4) zum Dämpfen der Verlagerung des aufgehängten Teils (6) relativ zum festen Teil (8), wobei die Dämpfungsmittel (4) elektromechanische Dämpfungsmittel sind, umfassend wenigstens eine Gleichstromversorgungsquelle (14), wenigstens n Gruppen, umfassend einen elektrischen Widerstand (R1,...Rn) sowie einen Kondensator mit variabler Kapazität (C1,...Cn), oder eine Untergruppe von Kondensatoren mit variabler Kapazität, die parallel zueinander angeschlossen sind, wobei der Kondensator oder die Untergruppe von Kondensatoren in Reihe mit dem Widerstand verbunden ist/sind, wobei die n Gruppen parallel an der Gleichstromversorgungsquelle (14) derart angeschlossen sind, dass sie n Kreise mit der gleichen Stromversorgungsquelle bilden, oder wobei jede Gruppe an einer Gleichstromversorgungsquelle angeschlossen ist, wobei jeder Kondensator mit variabler Kapazität (C) teilweise durch das aufgehängte Teil (6) und teilweise durch das feste Teil (8) derart gebildet ist, dass eine Verlagerung des aufgehängten Teils (6) eine Variation der Kapazität des Kondensators mit variabler Kapazität (C) bewirkt.

2. Struktur nach Anspruch 1, bei der die Widerstände von wenigstens zwei Gruppen zusammengelegt sind.

3. Struktur nach Anspruch 1 oder 2, bei der n eine gerade Zahl ist, und die Struktur ein festes Teil mit n elektrisch unabhängigen Motiven umfasst, wobei die n Kondensatoren (C1,...Cn) mit variabler Kapazität der n Gruppen durch die n Motive des festen Teils gebildet sind, wobei diese letztgenannten auf beiden Seiten des aufgehängten Teils (6) relativ zu einer Symmetrieebene des aufgehängten Teils (6) angeordnet sind.

4. Struktur nach einem der Ansprüche 1 bis 3, bei der das aufgehängte Teil einen Kamm umfasst, der mit n Zähnen ausgestattet ist, und bei der das feste Teil einen Kamm umfasst, der mit n Zähnen ausgestattet ist, die n Motive bilden, wobei die zwei Kämme interdigital sind, derart, dass ein Zahn eines Kamms zusammen mit einem Zahn eines anderen Kamms einen Kondensator mit variabler Kapazität bildet.

5. Struktur nach einem der Ansprüche 1 bis 4, bei der der wenigstens eine Kondensator mit variabler Kapazität (C) eine Luftspaltvariation aufweist.

6. Struktur nach einem der Ansprüche 1 bis 4, bei der der wenigstens eine Kondensator mit variabler Kapazität (C) eine Oberflächenvariation aufweist.

7. Struktur nach einem der Ansprüche 1 bis 6, bei der wenigstens eine Elektrode des wenigstens einen Kondensators mit variabler Kapazität (C) durch wenigstens eine Testelektrode (30) der Struktur gebildet ist.

8. Struktur nach einem der Ansprüche 1 bis 7, bei der der elektrische Widerstand (R) teilweise durch das feste Teil gebildet ist.

9. Struktur nach einem der Ansprüche 1 bis 8, bei der die Dämpfungsmittel derart gesteuert sind, dass eine variable Dämpfungskraft ausgeübt wird.

10. Struktur nach einem der Ansprüche 1 bis 9, umfassend Mittel zur Erfassung der Verlagerung des aufgehängten Teils, die einen Trägheitssensor bilden.

11. Struktur nach Anspruch 10, bei der der Trägheitssensor ein Beschleunigungsmesser ist.

12. Struktur nach Anspruch 10, umfassend Mittel zur Anregung wenigstens eines Teils des aufgehängten Teils.

13. Struktur nach Anspruch 12, bei der die Dämpfungsmittel derart gesteuert sind, dass eine variable Dämpfungskraft ausgeübt wird, und bei der der Trägheitssensor ein Gyroskop ist.

14. Baugruppe, umfassend wenigstens zwei Trägheitssensoren, die auf dem gleichen Substrat integriert sind, wobei wenigstens einer der zwei Trägheitssensoren ein Trägheitssensor nach einem der Ansprüche 10 bis 13 ist.

**15.** Baugruppe nach Anspruch 14, umfassend ein Gyroskop und einen Beschleunigungsmesser nach den Ansprüchen 11 und 13, wobei das Gyroskop und der Beschleunigungsmesser in einem Hohlraum eingekapselt sind, wobei die Dämpfungsmittel derart ausgelegt sind, dass der Beschleunigungsmesser einen geringen Qualitätsfaktor aufweist.

**16.** Verfahren zur Herstellung einer Struktur oder einer Baugruppe nach einem der Ansprüche 1 bis 15, umfassend die Schritte:

- Herstellen wenigstens eines elektrischen Widerstands der Dämpfungsmittel auf oder in dem Substrat, das dazu ausgelegt ist, wenigstens teilweise das feste Teil zu bilden,
- Herstellen des aufgehängten Teils und des festen Teils der Struktur,
- Befreien wenigstens des aufgehängten Teils.

**17.** Verfahren zur Herstellung nach Anspruch 16, bei der das Herstellen des wenigstens einen elektrischen Widerstands einen Schritt des Dotierens derart umfasst, dass der elektrische Widerstand des Teils des Materials gesteuert wird, in dem der Widerstand (R) hergestellt wird.

**18.** Verfahren zur Herstellung nach Anspruch 16 oder 17, umfassend einen Schritt des Bildens einer Schutzschicht auf dem elektrischen Widerstand vor der Herstellung des aufgehängten Teils und des festen Teils der Struktur.

**Claims**

**1.** Microelectromechanical and/or nanoelectromechanical structure comprising at least one fixed part (8) and at least one part (6) suspended from the fixed part (8) and means (4) of damping the displacement of the part (6) suspended from the fixed part (8), said damping means (4) being electromechanical damping means comprising at least one DC power supply source (14), at least n assemblies comprising an electrical resistor (R1,...Rn) and a variable capacitor (C1,...Cn) or a subassembly of variable capacitors connected in parallel, in series with the resistor, said n assemblies being connected in parallel on the DC power supply source (14), so as to form n loops with the same power supply source or each assembly being connected to a DC power supply source, , each variable capacitor (C) being formed partly by the suspended part (6) and partly by the fixed part (8) such that displacement of the suspended part (6) causes a variation of the capacitance of said variable capacitor (C).

**2.** Structure according to claim 1, in which the resistors of at least two assemblies are the same.

**3.** Structure according to claim 1 or 2, in which n is an even number and the structure comprises a fixed part with n electrically independent patterns, the n variable capacitors (C1,...Cn) in the n assemblies being formed by said n patterns in the fixed part, which are arranged on each side of the suspended part (6) relative to a plane of symmetry of said suspended part (6).

**4.** Structure according to claim 1 or 2, in which the inertial mass comprises a comb with n teeth, and the fixed part comprises a comb with n teeth forming n patterns, the two combs being interdigitised such that one tooth of one comb and one tooth of another comb together form a variable capacitor.

**5.** Structure according to claim 1 or 2, in which the at least one variable capacitor (C) is a variable air gap capacitor.

**6.** Structure according to claim 1 or 2, in which the at least one variable capacitor (C) is a variable area capacitor.

**7.** Structure according to claim 1 or 2, in which at least one electrode of the at least one variable capacitor (C) is formed by at least one test electrode (30) of the structure.

**8.** Structure according to claim 1 or 2, in which the electrical resistor (R) is partly formed by the fixed part.

**9.** Structure according to claim 1 or 2, in which the damping means are controllable so as to apply a variable damping force.

**10.** Structure according to claim 1 or 2, comprising means of detecting displacements of the suspended part and forming an inertial sensor.

**11.** Structure according to claim 10, in which the inertial sensor is an accelerometer.

**12.** Structure according to claim 10, comprising means of exciting at least part of the suspended part.

**13.** Structure according to claim 12, in which the damping means are controllable so as to apply a variable damping force, and in which the inertial sensor is a gyroscope.

**14.** Assembly comprising at least two inertial sensors integrated onto a single substrate, at least one of the two inertial sensors is an inertial sensor according to one of claims 10 to 13.

**15.** Assembly according to claim 14, comprising a gyroscope according to claim 13 and an accelerometer according to claim 11, said gyroscope and said accelerometer being encapsulated in a cavity, the damping means being such that the accelerometer has a low quality factor.

**16.** Process for making a structure or an assembly according to one of claims 1 to 15, comprising the following steps:

- make at least one electrical resistor of the damping means on or in a substrate that will at least partly form the fixed part,
- make the suspended part and the fixed part of the structure
- release at least the suspended part.

**17.** Production process according to claim 16, in which the step to make said at least electrical resistor comprises a doping step so as to control the electrical resistivity of the part of the material in which the resistor (R) is made.

**18.** Production process according to claim 16 or 17, comprising a step to form a protective layer on said electrical resistor before production of the suspended part and the fixed part of the structure.

FIG. 1A

FIG. 1B

FIG. 2

FIG. 3A

FIG. 3B

FIG. 3C

FIG. 4A

FIG. 4B

FIG. 5

FIG. 6

FIG. 7

FIG. 8

FIG. 9A

FIG. 9B

FIG. 9C

FIG. 9D

FIG. 9E

FIG. 9F

FIG. 9G

MEMS

112

116

106

104

R

FIG. 9H

MEMS

116

R

102

FIG. 9I

FIG. 10A

FIG. 10B

c1(x)    6    c2(x)

F1    $x$   $\vec{e}_x$    F2

i1      i2

R      R

V0

Fig 11A

c1(x)    6    c2(x)

F1    $x$   $\vec{e}_x$    F2

i1      i2

$R_1$   V01   V02   $R_2$

:

Fig 11B

c1(x)      c2(x)

R

V0

206        208       206'

Fig. 12

c1(x)

R

c2(x)       V0

306

Mode 1        Mode 2

Fig. 13

Fig. 14